# EUROPEAN PATENT SPECIFICATION

(11) **EP 2 645 115 B1**
(45) Date of publication and mention of the grant of the patent: **18.05.2016**
(21) Application number: 11845067.5
(22) Date of filing: 21.02.2011
(51) Int. Cl.: G01R 31/36, H01M 10/44, H02J 7/00, H02J 7/02

(54) **BATTERY CHARGE DETECTION METHOD AND CHARGE DETECTION DEVICE**
BATTERIELADEDETEKTIONSVERFAHREN UND LADEDETEKTIONSEINRICHTUNG
PROCÉDÉ DE DÉTECTION DE CHARGE DE BATTERIE ET DISPOSITIF DE DÉTECTION DE CHARGE

(30) Priority: 29.11.2010 CN 201010563933
(43) Date of publication of application: 02.10.2013
(73) Proprietor: ZTE Corporation, Shenzhen, Guangdong 518057 (CN)
(72) Inventor: XUE, Tao, Shenzhen Guangdong 518057 (CN)
(74) Representative: Price, Nigel John King
(86) International application number: PCT/CN2011/071139
(87) International publication number: WO 2012/071809

(56) References cited:
- EP-A2- 1 686 672
- CN-A- 1 794 001
- CN-A- 101 232 110
- CN-A- 101 630 762
- DE-A1- 3 128 852
- JP-A- 2002 216 857
- JP-A- 2003 164 071
- US-A- 5 594 321
- US-A- 5 642 032
- US-A1- 2005 225 301

## Description

### TECHNICAL FIELD

The disclosure relates to the field of batteries, and more particularly to a battery charge detection method and a charge detection device.

### BACKGROUND

With continuous development of communication technologies, more and more wireless terminal devices have been seen in people's life. These wireless mobile terminal devices usually need to be powered by built-in or external batteries so that they are convenient to carry and can meet the requirement of mobility and these batteries are charged by chargers. Charging principles and a charge course of the prior art are generally as described below:
1) constant current charging phase, in which the charge current of a charger keeps constant, the quantity of charged electricity increases rapidly and the voltage of a battery increases;
2) constant voltage charging phase, in which the charging voltage of the charger keeps constant, the quantity of the charged electricity continues to increase, the voltage of the battery increases slowly and the charge current decreases;
3) the battery is fully charged, the charge current decreases to below a floating charge conversion current, and the charging voltage of the charger decreases to a floating charge voltage;
4) floating charge charging phase, in which the charging voltage of the charger is maintained as the floating charge voltage.

Such a charge course is only applicable to a normal charge course. However, in some abnormal cases during the charge course, especially when components of some batteries or chargers are malfunctioned, due to the lack of charging protection, the batteries are always not fully charged and there are no corresponding prompts. The charging time is very long and charging is displayed all the time, but the chargers are not working actually. When there are prompts that charging has been completed, the service time is very short, and the batteries will change from a fully charged state to a not fully charged state, or prompts that the batteries must be charged will be displayed soon etc.

Document US 5642032 A discloses a charging apparatus charging a battery assembly including a plurality of secondary batteries. After the charging apparatus detects a full charge level, the apparatus stops charging. Then, when the charge level of the battery assembly falls below a predetermined charge level, the charging apparatus resumes charging in order to maintain the secondary battery assembly at a full charge level. The charging apparatus monitors the charging after charging is resumed. When the charging apparatus detects that the charging process after resumption of charging is abnormal, the apparatus modifies the charging.

Document EP 1686672 A2 discloses an electronic apparatus with a secondary battery as a power source, in which a charge time and a terminal voltage of the secondary battery is monitored and compared with respective thresholds to detect the abnormalities during the charging course.

Document JP 2003 164071 A discloses a method and apparatus having function of the charge control for the battery, in which when a processor 1 has not detected a full level, timer 2 continues timing; when the counted value detected by timer 2 reaches a threshold, informing the processor that the counted values reach the threshold, determining the charge state of the battery based on the voltage value; if the voltage value indication is normal, the charging is continued and the timer is initiated again.

### SUMMARY

The major technical problem to be solved by the disclosure is to provide a battery charge detection method and a charge detection device. A fault occurring in a charge course of the battery can be detected via the method and the device.

To solve the technical problem above, a battery charge detection method of the disclosure applies the following technical solution:
a battery charge detection method, including:
   sets charge parameters and detection parameters of a current rechargeable battery, wherein the charge parameters include: a full charge voltage, a charge critical voltage, and a rating charge time, and the detection parameters include: a detection time, a sampling period and the number of sampling times;
   detects a voltage of the current rechargeable battery, determines whether the detected voltage is more than or equal to the full charge voltage, and whether the detected voltage is still more than or equal to the full charge voltage after the preset detection time; if yes, confirms it is a normal charge; otherwise, samples voltages of the current rechargeable battery according to the preset sampling period and the number of sampling times;
   determines whether all sampled voltages are more than the charge critical voltage and follow a monotone increasing trend; if yes, confirms it is a normal charge; otherwise, obtains the current charge time of the current rechargeable battery to obtain a first charge time;
   determines whether the obtained first charge time is more than the rating charge time; if yes, confirms a first charge fault occurs.

Further, the charge parameters further include a maximum charge time. The method may further include: obtaining the current charge time of the current rechargeable battery to obtain a second charge time if not all the sampled voltages are more than the charge critical voltage; determining whether the obtained second charge time is more than the maximum charge time; if yes, confirming a second charge fault occurs.

Further, the rating charge time may be a value obtained by calculating according to a capacity and a charge current of the current rechargeable battery.

Further, the maximum charge time may be twice as much as the rating charge time.

Further, the method may further include: stopping charging and prompting a user that the charge fault occurs when confirms a charge fault occurs.

Based on the battery charge detection method above, the disclosure further provides a charge detection device. The device includes: a setting module, a detecting module, a sampling module, a comparing module and a control module, wherein
the setting module is configured to set charge parameters and detection parameters of a current rechargeable battery, wherein the charge parameters include: a full charge voltage, a charge critical voltage, and a rating charge time, and the detection parameters include: a detection time, a sampling period and the number of sampling times;
the detecting module is configured to detect a voltage of the current rechargeable battery;
the sampling module is configured to sample voltages of the current rechargeable battery according to the sampling period and the number of sampling times set by the setting module;
the comparing module is configured to compare the voltage detected by the detecting module with the full charge voltage; after the preset detection time and when the detected voltage is less than the full charge voltage, the comparing module is configured to compare the voltages sampled by the sampling module with the charge critical voltage; when the sampled voltages are more than the charge critical voltage but not follow a monotone increasing trend, the comparing module is configured to compare an obtained first charge time with the rating charge time;
the control module is configured to control the detecting module to detect whether the voltage of the current rechargeable battery is more than or equal to the full charge voltage, and whether the detected voltage is still more than or equal to the full charge voltage after the detection time; if yes, confirms it is a normal charge; otherwise, controls the sampling module to sample the voltages of the current rechargeable battery according to the detecting and sampling period and the number of detecting and sampling times, and calls the comparing module to compare whether all sampled voltages are more than the charge critical voltage and follow the monotone increasing trend; if yes, confirms it is a normal charge; otherwise, obtains the current charge time of the current rechargeable battery to obtain the first charge time and calls the comparing module to compare whether the first charge time is more than the rating charge time; if yes, confirms a first charge fault occurs.

Further, the charge parameters may further include maximum charge time. The control module may be further configured to obtain the current charge time of the current rechargeable battery to obtain a second charge time if not all the sampled voltages are more than the charge critical voltage, and call the comparing module to compare whether the second charge time is more than the maximum charge time; if yes, the control module confirms a second charge fault occurs.

Further, the charge detection device may further include a prompting module connected with the control module. The prompting module is configured to prompt that a charge fault occurs and control to stop charging when the control module confirms a charge fault occurs and after being called by the control module.

The disclosure has the following beneficial effect: by detecting a voltage and sampling voltages of a current rechargeable battery, and comparing the voltages with a preset full charge voltage and a charge critical voltage respectively, when the detected voltage does not meet the condition that the detected voltage is still more than or equal to the full charge voltage after preset detection time, and the sampled voltages does not meet the condition that the sampled voltages are more than the charge critical voltage and follow a monotone increasing trend, then obtains a first charge time through obtaining charge time of the current rechargeable battery, compares the first charge time with a set rating charge time, and confirms a first charge fault occurs when the obtained first charge time is more than the rating charge time, so as to detect a charge fault occurring in a battery charge course by detecting a voltage of a rechargeable battery and obtaining charge time of the rechargeable battery.

### BRIEF DESCRIPTION OF THE DRAWINGS

Fig. 1 is a structure block diagram of an embodiment of a charge detection device of the disclosure;
Fig. 2 is a structure block diagram of another embodiment of a charge detection device of the disclosure;
Fig. 3 is a flowchart of an embodiment of a battery charge detection method corresponding to the charge detection device in Fig. 1; and
Fig. 4 is a flowchart of an embodiment of a battery charge detection method corresponding to the charge detection device in Fig. 2.

### DETAILED DESCRIPTION

The disclosure will be further described in details below through the specific embodiments in combination with the accompanying drawings.

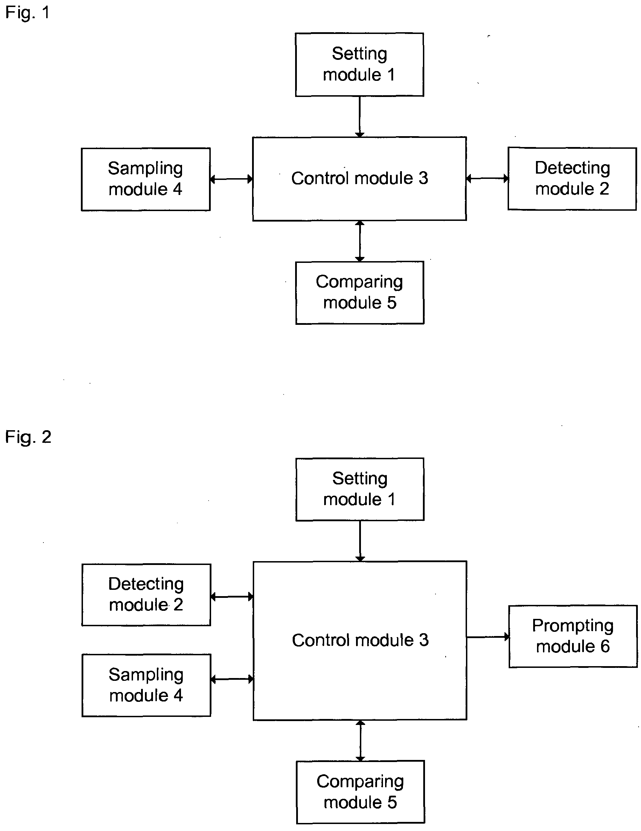

Fig. 1 shows a structure block diagram of an embodiment of a charge detection device of the disclosure. As shown in the figure, the charge detection device includes: a control module 3, and a setting module 1, a detecting module 2, a sampling module 4 and a comparing module 5 which are connected with the control module 3,
wherein the setting module 1 is configured to set charge parameters including a full charge voltage, a charge critical voltage, rating charge time and maximum charge time etc. and detection parameters including detection time, a sampling period and the number of sampling times etc. of a current rechargeable battery. In an embodiment of the disclosure, the charge parameters and the detection parameters may be set according to properties of the current rechargeable battery,
wherein the detecting module 2 is configured to detect a voltage of the current rechargeable battery; the sampling module 4 is configured to sample voltages of the current rechargeable battery according to the sampling period and the number of sampling times set by the setting module,
wherein the comparing module 5 is configured to compare the voltage detected by the detecting module 2 with the set full charge voltage; after the preset detection time and when the detected voltage is less than the full charge voltage, the comparing module 5 is configured to compare the voltages sampled by the sampling module 4 with the set charge critical voltage; when the sampled voltages are more than the set charge critical voltage but not follow a monotone increasing trend, the comparing module 5 is configured to compare the obtained first charge time with the set rating charge time,
the control module 3 is configured to control the detecting module 2 to detect the voltage of the current rechargeable battery and call the comparing module 5 to compare whether the detected voltage is more than or equal to the full charge voltage, and whether the detected voltage is still more than or equal to the full charge voltage after the preset detection time; if yes, confirms it is a normal charge; otherwise, controls the sampling module 4 to sample the voltages of the battery according to the detecting and sampling period and the number of detecting and sampling times, and calls the comparing module 5 to compare whether all sampled voltages are more than the charge critical voltage and follow the monotone increasing trend; if yes, the control module 3 confirms it is a normal charge; otherwise, obtains current charge time of the battery to obtain the first charge time and calls the comparing module 5 to compare whether the first charge time is more than the rating charge time; if yes, the control module 3 confirms a first charge fault occurs; if not all sampled voltages are more than the set charge critical voltage, the control module 3 obtains the current charge time of the battery to obtain a second charge time and then calls the comparing module 5 to compare whether the second charge time is more than the maximum charge time; if yes, the control module 3 confirms a second charge fault occurs; otherwise, keeps on charging.

In the embodiment, if all sampled voltages are determined to be more than the charge critical voltage and follow the monotone increasing trend, then the first charge time refers to the duration from the moment when the battery starts charging until the moment of the last sampling; if not all sampled voltages are determined to be more than the charge critical voltage, then the second charge time refers to the duration from the moment when the battery starts charging until the moment of the last sampling. In the embodiment, the control module 3 is provided with a timer which measures charge time of the battery from the moment when the battery starts charging so that the control module 3 can obtain the current charge time of the rechargeable battery directly if necessary.

The charge detection device of the embodiment detects the voltage of the rechargeable battery through the detecting module 2, obtains the charge time of the rechargeable battery and compares the detected voltage and the obtained charge time with the preset charge parameters through the comparing module 5, so as to confirm a charge fault occurring in a charge course of the battery

As shown in Fig. 2, in another embodiment of the disclosure, the charge detection device includes a control module 3, and a setting module 1, a detecting module 2, a sampling module 4 and a comparing module 5 which are connected with the control module 3, and further includes a prompting module 6 connected with the control module 3. wherein the setting module 1 is configured to set charge parameters including a full charge voltage, a charge critical voltage, rating charge time and maximum charge time etc. and detection parameters including detection time, a sampling period and the number of sampling times etc. of a current rechargeable battery. In an embodiment of the disclosure, the charge parameters and the detection parameters may be set according to properties of the current rechargeable battery. The detecting module 2 is configured to detect a voltage of the current rechargeable battery; the sampling module 4 is configured to sample voltages of the current rechargeable battery according to the sampling period and the number of sampling times set by the setting module. The comparing module 5 is configured to compare the voltage detected by the detecting module 2 and the sampled voltages with the set full charge voltage and charge critical voltage respectively and compare the obtained first charge time of the current rechargeable battery with the set rating charge time. The control module 3 is configured to control the detecting module 2 to detect the voltage of the current rechargeable battery and call the comparing module 5 to compare whether the detected voltage is more than or equal to the full charge voltage, and whether the detected voltage is still more than or equal to the full charge voltage after the preset detection time; if yes, confirms it is a normal charge; otherwise, controls the sampling module 4 to sample the voltages of the battery according to the detecting and sampling period and the number of detecting and sampling times, and calls the comparing module 5 to compare whether all sampled voltages are more than the charge critical voltage and follow a monotone increasing trend; if yes, the control module 3 confirms it is a normal charge; otherwise, obtains current charge time of the battery to obtain the first charge time and calls the comparing module 5 to compare whether the first charge time is more than the rating charge time; if yes, the control module 3 confirms a first charge fault occurs, stops charging and calls the prompting module 6 to prompt a user that a first charge fault occurs; if not all sampled voltages are more than the set charge critical voltage, the control module 3 obtains the current charge time of the battery to obtain a second charge time and then calls the comparing module 5 to compare whether the second charge time is more than the maximum charge time; if yes, the control module 3 confirms a second charge fault occurs, stops charging and calls the prompting module 6 to prompt a user that a second charge fault occurs; otherwise, keeps on charging.

The charge detection device of the embodiment detects the voltage and samples the voltages of the rechargeable battery through the detecting module 2 and obtains the charge time thereof, compares the obtained voltages with the full charge voltage and the charge critical voltage respectively through the comparing module 5, and compares the obtained charge time with the rating charge time or the maximum charge time to detect a charge fault occurring in the charge course of the battery, control to stop charging and prompt the user that a corresponding charge fault occurs by calling the prompting module 6.

The charge detection device of the disclosure may be applied to various terminals, e.g. a mobile phone and a desktop telephone etc. A telecommunication operator only needs to modify user terminal software properly to satisfy requirements, for example, by adding a corresponding service software module.

Based on the charge detection device above, the disclosure further provides a charge detection method, which will be described in details in combination with the specific embodiments and accompanying drawings.

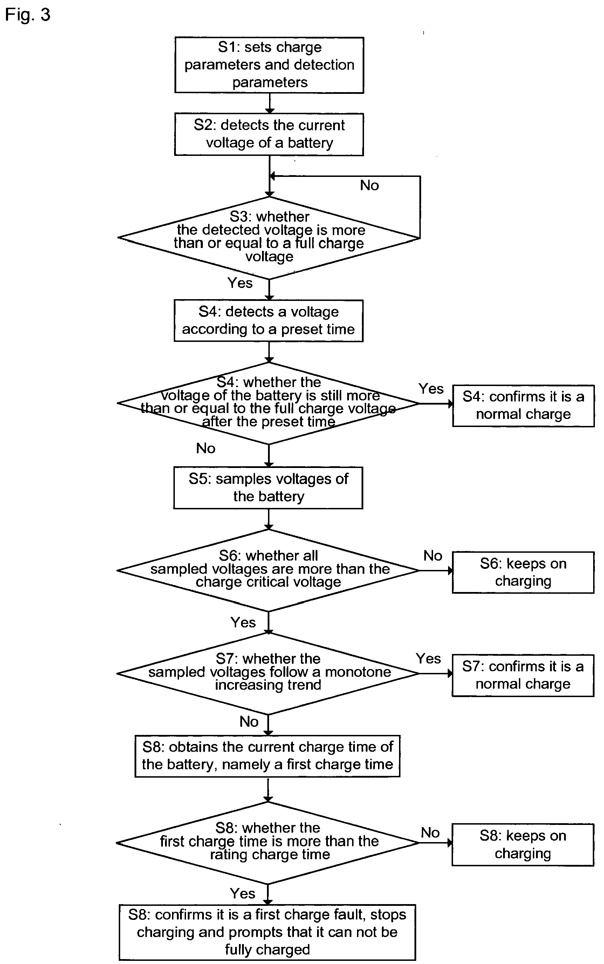

As shown in Fig. 3, in an embodiment of a battery charge detection method of the disclosure, the method includes the following steps:
Step S1: presets charge parameters including a full charge voltage, a charge critical voltage and maximum charge time, and detection parameters including detection time, a sampling period and the number of sampling times of a current rechargeable battery.
   in an embodiment of the disclosure, the charge parameters and the detection parameters may be set according to properties of the current rechargeable battery, wherein the full charge voltage is set to be slightly less than a charge cutoff voltage of the battery; the charge critical voltage is set to be about 80% to 90% of the charge cutoff voltage and less than the set full charge voltage; the rating charge time is an obtained time calculated according to a capacity of the battery and an output current of a charger; the maximum charge time is set to be about twice as much as the rating charge time, e.g. the capacity of the battery is 1000mAh and the output current of the charger is 500mA, then the time required by charging at the moment should be 1000mAh/500mA=2 hours, and the maximum charge time is 4 hours. Of course, the maximum charge time may be set as other values according to the properties of the rechargeable battery, wherein the preset detection time should not be too long, otherwise overcharging will occur, e.g. the detection time is set to be about 1 minute; the detecting and sampling period should not be set too long, e.g. an appropriate detecting and sampling period is not longer than 5 minutes, then the corresponding number of sampling times may be set as 30 times, and the sampling is performed at an interval of 10 seconds.
Step S2: detects a voltage of the current rechargeable battery.
Step S3: compares whether the detected voltage is more than or equal to the set full charge voltage; if yes, performs Step S4.
Step S4: after the preset detection time, determines whether the detected voltage of the battery is still more than or equal to the full charge voltage; if yes, confirms it is a normal charge; otherwise, performs Step S5.
Step S5: samples voltages of the battery according to the preset detecting period and number of detecting times.
Step S6: compares whether all sampled voltages are more than the charge critical voltage; if yes, performs Step S7; otherwise, keeps on charging.
Step S7: determines whether the sampled voltages follow a monotone increasing trend; if yes, confirms it is a normal charge; otherwise, performs Step S8.

The monotone increasing trend of the sampled voltages of the battery in the embodiment may be a straight line increasing trend, a polygonal line increasing trend or a curve increasing trend. Of course, the monotone increasing trend may be other increasing trends, i.e. the normal charge is confirmed as long as all sampled voltages are more than the charge critical voltage and each sampled voltage is more than or equal to the previous sampled voltage.

Step S8: obtains the current charge time of the battery to obtain a first charge time, and compares whether the obtained first charge time is more than the rating charge time of the battery; if yes, confirms it is a first charge fault, stops charging and prompts, at the same time, a user that the battery cannot be fully charged; otherwise, keeps on charging.

The current charge time of the battery here is the duration from the moment when the battery starts charging to the last sampling performed to the battery.

Because of aging of the battery or the use of an inappropriate charger, the condition that the battery is not fully charged after the charging ends sometimes occurs. The method detects the voltage and charge time of the current rechargeable battery, and compares the charge voltage and charge time with the preset charge critical voltage and rating charge time respectively. When the voltage of the battery is more than the charge critical voltage and the charge time is not more than the rating charge time, or the voltage of the battery is not more than the charge critical voltage and the charge time is more than the rating charge time, or the voltage of the battery is not more than the charge critical voltage and the charge time is not more than the rating charge time, the battery will be charged continuously to avoid the phenomenon that the battery is not fully charged after the charging ends. When the voltage of the battery is more than the charge critical voltage and the charge time is more than the rating charge time, a first charge fault is confirmed and the charging is stopped, and the user is prompted that a charge fault occurs to avoid the phenomenon that the charging cannot be stopped and there are no prompts when the battery cannot be fully charged.

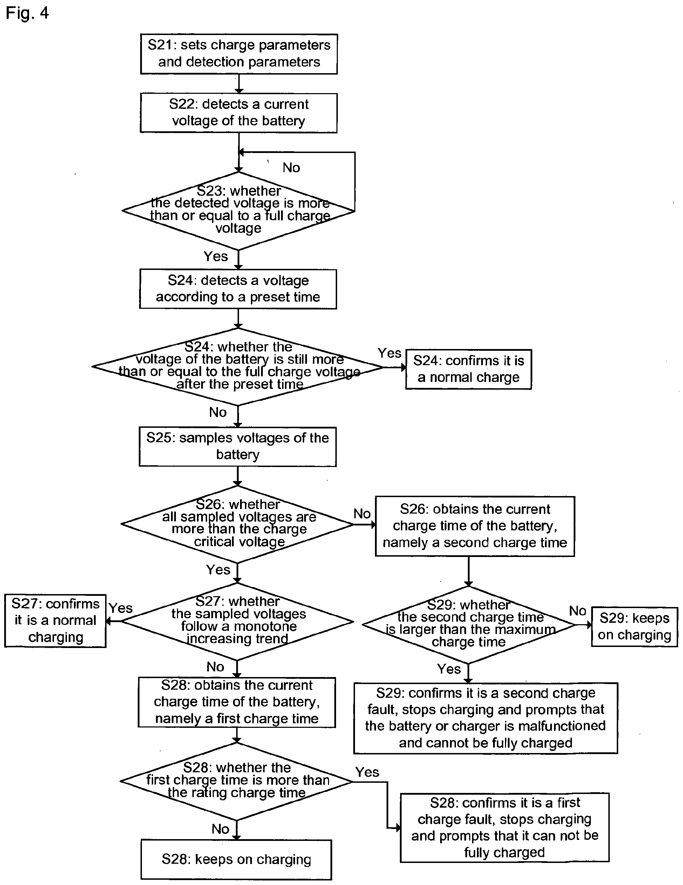

Sometimes, the battery cannot be fully charged after being charged for a long period of time because of a fault of the battery itself or the charger. The disclosure further detects the charge time of the battery, compares the charge time with the maximum charge time, and stops charging when the charge time reaches the maximum charge time so as to avoid the phenomenon that the battery cannot be fully charged after being charged for a long period of time. As shown in Fig. 4, another embodiment of a method of the disclosure includes the following steps:
Step S21: presets charge parameters and detection parameters of a current rechargeable battery. The charge parameters include: a full charge voltage, a charge critical voltage and maximum charge time. The detection parameters include: detection time, a sampling period and the number of sampling times.
Step S22: detects a voltage of the current rechargeable battery.
Step S23: compares whether the detected voltage is more than or equal to the set full charge voltage; if yes, performs Step S4.
Step S24: compares whether the detected voltage of the battery is still more than or equal to the full charge voltage after the preset detection time; if yes, confirms it is a normal charge; otherwise, performs Step S25.
Step S25: samples voltages of the battery according to the preset detecting period and the number of detecting times.
Step S26: compares whether all sampled voltages are more than the charge critical voltage; if yes, performs Step S27; otherwise, obtains the current charge time of the battery to obtain a second charge time, and performs Step S29.

The current charge time of the battery here is the duration from the moment when the battery starts charging to the last sampling of the battery.

Step S27: determines whether the sampled voltages follow a monotone increasing trend; if yes, confirms it is a normal charge; otherwise, performs Step S28.

Step S28: obtains the current charge time of the battery to obtain the first charge time, and compares whether the obtained first charge time is more than the rating charge time of the battery; if yes, confirms a first charge fault occurs, stops charging and prompts a user that the first charge fault occurs and the battery cannot be fully charged; otherwise, keeps on charging.

Step S29: compares whether the second charge time is more than the maximum charge time; if yes, confirms a second charge fault occurs, stops charging and prompts the user that a second charge fault occurs, the battery or a charger is abnormal; otherwise, keeps on charging.

The method of the disclosure detects the voltage and charge time of the rechargeable battery, compares the voltage and charge time with the full charge voltage and the charge critical voltage, detects the charge time of the rechargeable battery and compares the charge time with the rating charge time and the maximum charge time respectively, when the charge voltage of the battery is more than the charge critical voltage and the second charge time is more than or equal to the maximum charge time, confirms it is the second charge fault, controls to stop charging and simultaneously prompts the user that a charge fault occurs. The method of the disclosure can not only detect a fault in the charge course of the battery, but also effectively avoid the problem that the battery or the charger cannot stop charging timely when the battery or the charger are abnormal and the abnormality cannot be prompted to the user.

The above are further detailed descriptions made to the disclosure in conjunction with specific embodiments, but it should not be considered that the specific embodiments of the disclosure are only limited to these descriptions. For one of ordinary skill in the art to which the disclosure belongs, many simple deductions and replacements can be made without departing from the inventive concept. Such deductions and replacements should fall within the scope of protection of the disclosure.

## Claims

1. A battery charge detection method, comprises:
setting (S21) charge parameters and detection parameters of a current rechargeable battery, wherein the charge parameters comprise: a full charge voltage, a charge critical voltage, and a rating charge time, and the detection parameters comprise: a detection time, a sampling period and the number of sampling times;
detecting (S22) a voltage of the current rechargeable battery, determining (S23, S24) whether the detected voltage is more than or equal to the full charge voltage, and whether the detected voltage is still more than or equal to the full charge voltage after the preset detection time; if yes, confirming it is a normal charge; otherwise, sampling (S25) voltages of the current rechargeable battery according to the preset sampling period and the number of sampling times;
determining (S26, S27) whether all sampled voltages are more than the charge critical voltage and follow a monotone increasing trend; if yes, confirming it is a normal charge; otherwise, obtaining (S28) the current charge time of the current rechargeable battery to obtain a first charge time;
determining whether the obtained first charge time is more than the rating charge time; if yes, confirming a first charge fault occurs.

2. The method according to claim 1, wherein the charge parameters further comprise a maximum charge time; the method further comprises: obtaining (29) the current charge time of the current rechargeable battery to obtain a second charge time if not all the sampled voltages are more than the charge critical voltage; determining whether the second charge time is more than the maximum charge time; if yes, confirming a second charge fault occurs.

3. The method according to claim 1 or 2, wherein the rating charge time is a value obtained by calculating according to a capacity and a charge current of the current rechargeable battery.

4. The method according to claim 2, wherein the maximum charge time is twice as much as the rating charge time.

5. The method according to claim 4, wherein the method further comprises: stopping charging and prompting a user that the charge fault occurs when a charge fault occurs.

6. A charge detection device, comprises: a setting module (1), a detecting module (2), a sampling module (4), a comparing module (5) and a control module (3), wherein
the setting module (1) is configured to set charge parameters and detection parameters of a current rechargeable battery, wherein the charge parameters comprise: a full charge voltage, a charge critical voltage, and a rating charge time, and the detection parameters comprise: a detection time, a sampling period and the number of sampling times;
the detecting module (2) is configured to detect a voltage of the current rechargeable battery;
the sampling module (4) is configured to sample voltages of the current rechargeable battery according to the detecting and sampling period and the number of detecting and sampling times set by the setting module (1);
the comparing module (5) is configured to compare the voltage detected by the detecting module (2) with the full charge voltage; after the preset detection time and when the detected voltage is less than the full charge voltage, the comparing module (5) is configured to compare the voltages sampled by the sampling module (4) with the charge critical voltage; when all sampled voltages are more than the charge critical voltage but not follow a monotone increasing trend, the comparing module is configured to compare an obtained first charge time with the rating charge time;
the control module (3) is configured to control the detecting module (2) to detect a voltage of the current rechargeable battery, and call the comparing module (5) to compare whether the detected voltage is more than or equal to the full charge voltage, and whether the detected voltage is still more than or equal to the full charge voltage after the detection time; if yes, confirms it is a normal charge; otherwise, controls the sampling module (4) to sample the voltages of the current rechargeable battery according to the detecting and sampling period and the number of detecting and sampling times, and calls the comparing module (5) to compare whether all sampled voltages are more than the charge critical voltage and follow the monotone increasing trend; if yes, confirms it is a normal charge; otherwise, obtains the current charge time of the current rechargeable battery to obtain the first charge time, and calls the comparing module (5) to compare whether the first charge time is more than or equal to the rating charge time; if yes, confirms a first charge fault occurs.

7. The charge detection device according to claim 6, wherein the charge parameters further comprise a maximum charge time; the control module (3) is further configured to obtain the current charge time of the current rechargeable battery to obtain a second charge time if not all the sampled voltages are more than the charge critical voltage, and call the comparing module (5) to compare whether the second charge time is more than the maximum charge time; if yes, the control module (3) confirms a second charge fault occurs.

8. The charge detection device according to claim 6 or 7, wherein the charge detection device further comprises a prompting module (6) connected with the control module (3); the prompting module (6) is configured to prompt that a charge fault occurs to a user and control to stop charging when the control module (3) confirms a charge fault occurs and after being called by the control module (3).

## Patentansprüche

1. Verfahren zur Bestimmung des Ladezustands einer Batterie, umfassend:
Einrichten (S21) von Ladeparametern und Bestimmungsparametern einer durch Strom wiederaufladbaren Batterie, wobei die Ladeparameter umfassen: eine volle Ladespannung, eine kritische Ladespannung und eine Bewertungsladezeit, wobei die Bestimmungsparameter umfassen: einen Bestimmungszeitpunkt, einen Messzeitraum und die Anzahl der Messzeitpunkte;
Bestimmen (S22) einer Spannung der durch Strom wiederaufladbaren Batterie, Festlegen (S23, S24), ob die bestimmte Spannung höher oder gleich der vollen Ladespannung ist und ob die bestimmte Spannung nach dem vorgegebenen Bestimmungszeitpunkt immer noch höher oder gleich der vollen Ladespannung ist; falls zutreffend, Bestätigen, dass es eine normale Ladung ist; andernfalls Messen (S25) von Spannungen der durch Strom wiederaufladbaren Batterie entsprechend des vorgegebenen Messzeitraums und der Anzahl der Messzeitpunkte;
Festlegen (S26, S27), ob alle gemessenen Spannungen höher sind als die kritische Ladespannung und einer monoton ansteigenden Entwicklung folgen; falls zutreffend, Bestätigen, dass es eine normale Ladung ist; andernfalls Erhalten (S28) der Stromladezeit der durch Strom wiederaufladbaren Batterie, um eine erste Ladezeit zu erhalten;
Festlegen, ob die erhaltene erste Ladezeit länger ist als die Bewertungsladezeit; falls zutreffend, Bestätigen des Auftretens eines ersten Ladefehlers.

2. Verfahren nach Anspruch 1, wobei die Ladeparameter weiter eine maximale Ladezeit umfassen; wobei das Verfahren weiter umfasst: Erhalten (29) der Stromladezeit der durch Strom wiederaufladbaren Batterie, um eine zweite Ladezeit zu erhalten, falls nicht alle gemessenen Spannungen höher als die kritische Ladespannung sind; Festlegen, ob die zweite Ladezeit länger ist als die maximale Ladezeit; falls zutreffend, Bestätigen des Auftretens eines zweiten Ladefehlers.

3. Verfahren nach Anspruch 1 oder 2, wobei die Bewertungsladezeit ein Wert ist, der durch das Berechnen entsprechend einer Kapazität und eines Ladestroms der durch Strom wiederaufladbaren Batterie erhalten wird.

4. Verfahren nach Anspruch 2, wobei die maximale Ladezeit zweimal so lang ist wie die Bewertungsladezeit.

5. Verfahren nach Anspruch 4, wobei das Verfahren weiter umfasst:
Anhalten des Ladens und Angabe an einen Benutzer, dass der Ladefehler auftritt, wenn ein Ladefehler auftritt.

6. Ladebestimmungsvorrichtung, umfassend: ein Einrichtungsmodul (1), ein Bestimmungsmodul (2), ein Messmodul (4), ein Vergleichsmodul (5) und ein Steuermodul (3), wobei
das Einrichtungsmodul (1) dazu konfiguriert ist, Ladeparameter und Bestimmungsparameter einer durch Strom wiederaufladbaren Batterie einzurichten, wobei die Ladeparameter umfassen: eine volle Ladespannung, eine kritische Ladespannung und eine Bewertungsladezeit und wobei die Bestimmungsparamater umfassen: einen Bestimmungszeitpunkt, einen Messzeitraum und die Anzahl der Messzeitpunkte;
das Bestimmungsmodul (2) dazu konfiguriert ist, eine Spannung der durch Strom wiederaufladbaren Batterie zu bestimmen;
das Messmodul (4) dazu konfiguriert ist, Spannungen der durch Strom wiederaufladbaren Batterie entsprechend des Bestimmungs- und Messzeitraums und der Anzahl der Bestimmungs- und Messzeitpunkte, die vom Einrichtungsmodul (1) eingerichtet wurden, zu messen;
das Vergleichsmodul (5) dazu konfiguriert ist, die vom Bestimmungsmodul (2) bestimmte Spannung mit der vollen Ladespannung zu vergleichen; nach dem vorgegebenen Bestimmungszeitpunkt und wenn die bestimmte Spannung niedriger ist als die volle Ladespannung, ist das Vergleichsmodul (5) dazu konfiguriert, die vom Messmodul (4) gemessenen Spannungen mit der kritischen Ladespannung zu vergleichen; wenn alle gemessenen Spannungen höher sind als die kritische Ladespannung, aber keiner monoton ansteigenden Entwicklung folgen, ist das Vergleichsmodul dazu konfiguriert, eine erhaltene erste Ladezeit mit der Bewertungsladezeit zu vergleichen;
das Steuermodul (3) dazu konfiguriert ist, das Bestimmungsmodul (2) zum Bestimmen einer Spannung der durch Strom wiederaufladbaren Batterie zu steuern und das Vergleichsmodul (5) zu kontaktieren, um zu vergleichen, ob die bestimmte Spannung höher oder gleich der vollen Ladespannung ist und ob die bestimmte Ladespannung nach dem Bestimmungszeitpunkt immer noch höher oder gleich der vollen Ladespannung ist; falls zutreffend, bestätigt es, dass es eine normale Ladung ist; andernfalls, steuert es das Messmodul (4) zum Messen der Spannungen der durch Strom wiederaufladbaren Batterie entsprechend des Bestimmungs- und Messzeitraums und der Anzahl der Bestimmungs- und Messzeitpunkte und kontaktiert das Vergleichsmodul (5) zum Vergleichen, ob alle gemessenen Spannungen höher sind als die kritische Ladespannung und der monoton ansteigenden Entwicklung folgen; falls zutreffend, bestätigt es, dass es eine normale Ladung ist; andernfalls, erhält es die Stromladezeit der durch Strom wiederaufladbaren Batterie, um die erste Ladezeit zu erhalten und kontaktiert das Vergleichsmodul (5) zum Vergleichen, ob die erste Ladezeit länger oder gleich der Bewertungsladezeit ist; falls zutreffend, bestätigt es das Auftreten eines ersten Ladefehlers.

7. Ladebestimmungsvorrichtung nach Anspruch 6, wobei die Ladeparameter weiter eine maximale Ladezeit umfassen; wobei das Steuermodul (3) weiter dazu konfiguriert ist, die Stromladezeit der durch Strom wiederauflabdaren Batterie zu erhalten, um eine zweite Ladezeit zu erhalten, falls nicht alle gemessenen Spannungen höher sind als die kritische Ladespannung, und das Vergleichsmodul (5) zu kontaktieren, um zu vergleichen, ob die zweite Ladezeit länger ist als die maximale Ladezeit; falls zutreffend, bestätigt das Steuermodul (3) das Auftreten eines zweiten Ladefehlers.

8. Ladebestimmungsvorrichtung nach Anspruch 6 oder 7, wobei die Ladebestimmungsvorrichtung weiter ein Angabemodul (6) in Verbindung mit dem Steuermodul (3) umfasst; wobei das Angabemodul (6) dazu konfiguriert ist, für einen Benutzer das Auftreten eines Ladefehlers anzugeben und das Anhalten des Ladens zu steuern, wenn das Steuermodul (3) das Auftreten eines Ladefehlers bestätigt und nachdem es vom Steuermodul (3) kontaktiert wurde.

## Revendications

1. Procédé de détection de charge de batterie, comprenant les étapes consistant à :
régler (S21) les paramètres de charge et les paramètres de détection d'une batterie électrique rechargeable, les paramètres de charge comprenant : une tension de charge complète, une tension de charge critique, et un temps de charge de consigne, et les paramètres de détection comprenant : un temps de détection, une période d'échantillonnage et le nombre de temps d'échantillonnage ;
détecter (S22) une tension de la batterie électrique rechargeable, déterminer (S23, S24) si la tension détectée est supérieure ou égale à la tension de charge complète, et si la tension détectée est toujours supérieure ou égale à la tension de charge complète après le temps de détection prédéfini ; si oui, confirmer qu'il s'agit d'une charge normale ; sinon, échantillonner (S25) les tensions de la batterie électrique rechargeable selon la période d'échantillonnage prédéfinie et le nombre de temps d'échantillonnage ;
déterminer (S26, S27) si toutes les tensions échantillonnées sont plus élevées que la tension de charge critique et suivent une tendance d'augmentation monotone ; si oui, confirmer qu'il s'agit d'une charge normale ; sinon, obtenir (S28) le temps de charge électrique de la batterie électrique rechargeable pour obtenir un premier temps de charge ;
déterminer si le premier temps de charge obtenu est plus long que le temps de charge de consigne ; si oui, confirmer qu'une première défaillance de charge s'est produite.

2. Procédé selon la revendication 1, dans lequel les paramètres de charge comprennent également un temps maximum de charge ; le procédé consistant également à : obtenir (29) le temps de charge électrique de la batterie électrique rechargeable pour obtenir un deuxième temps de charge si toutes les tensions échantillonnées ne sont pas supérieures à la tension de charge critique ; déterminer si le deuxième temps de charge est plus long que le temps de charge maximum; si oui, confirmer qu'une seconde défaillance de charge s'est produite.

3. Procédé selon la revendication 1 ou 2, dans lequel le temps de charge de consigne est une valeur obtenue par calcul en fonction d'une capacité et d'un courant de charge de la batterie électrique rechargeable.

4. Procédé selon la revendication 2, dans lequel le temps maximum de charge est deux fois plus long que le temps de charge de consigne.

5. Procédé selon la revendication 4, le procédé consistant également à : arrêter la charge et avertir l'utilisateur d'une défaillance de charge lorsqu'une défaillance de charge se produit.

6. Dispositif de détection de charge, comprenant : un module de réglage (1), un module de détection (2), un module d'échantillonnage (4), un module de comparaison (5) et un module de commande (3),
le module de réglage (1) étant configuré pour définir les paramètres de charge et les paramètres de détection d'une batterie électrique rechargeable, les paramètres de charge comprenant : une tension de charge complète, une tension de charge critique et un temps de charge de consigne, et les paramètres de détection comprenant : un temps de détection, une période d'échantillonnage et le nombre de temps d'échantillonnage ;
le module de détection (2) étant configuré pour détecter une tension de la batterie électrique rechargeable ;
le module d'échantillonnage (4) étant configuré pour échantillonner les tensions de la batterie électrique rechargeable selon la période de détection et d'échantillonnage et le nombre de temps de détection et d'échantillonnage définis par le module de réglage (1) ;
le module de comparaison (5) étant configuré pour comparer la tension détectée par le module de détection (2) à la tension de charge complète ; après le temps de détection prédéfini et quand la tension détectée est moins élevée que la tension de charge complète, le module de comparaison (5) étant configuré pour comparer les tensions échantillonnées par le module d'échantillonnage (4) à la tension de charge critique ; quand toutes les tensions échantillonnées sont plus élevées que la tension de charge critique mais ne suivent pas une tendance d'augmentation monotone, le module de comparaison étant configuré pour comparer un premier temps de charge obtenu au temps de charge de consigne ;
le module de commande (3) étant configuré pour commander le module de détection (2) pour détecter une tension de la batterie électrique rechargeable, et appeler le module de comparaison (5) à comparer si la tension détectée est supérieure ou égale à la tension de charge complète, et si la tension détectée est toujours supérieure ou égale à la tension de charge complète après le temps de détection ; si oui, confirmer qu'il s'agit d'une charge normale ; sinon, commander le module d'échantillonnage (4) pour échantillonner les tensions de la batterie électrique rechargeable selon la période de détection et d'échantillonnage et le nombre de temps de détection et d'échantillonnage, et appeler le module de comparaison (5) à comparer si toutes les tensions échantillonnées sont plus élevées que la tension de charge critique et suivent la tendance d'augmentation monotone ; si oui, confirmer qu'il s'agit d'une charge normale ; sinon, obtenir le temps de charge électrique de la batterie électrique rechargeable pour obtenir le premier temps de charge, et appeler le module de comparaison (5) à comparer si le premier temps de charge est supérieur ou égal au temps de charge de consigne ; si oui, confirmer qu'une première défaillance de charge s'est produite.

7. Dispositif de détection de charge selon la revendication 6, dans lequel les paramètres de charge comprennent également un temps maximum de charge ; le module de commande (3) est également configuré pour obtenir le temps de charge électrique de la batterie électrique rechargeable pour obtenir un second temps de charge si toutes les tensions échantillonnées ne sont pas supérieures à la tension de charge critique, et appeler le module de comparaison (5) à comparer si le second temps de charge est plus élevé que le temps maximum de charge ; si oui, le module de commande (3) confirme qu'une deuxième défaillance de charge s'est produite.

8. Dispositif de détection de charge selon la revendication 6 ou 7, le dispositif de détection de charge comprenant également un module d'avertissement (6) connecté au module de commande (3) ; le module d'avertissement (6) étant configuré pour avertir un utilisateur qu'une défaillance de charge s'est produite et commander l'arrêt de la charge quand le module de commande (3) confirme qu'une défaillance de charge s'est produite et après avoir été appelé par le module de commande (3).
